# EUROPEAN PATENT SPECIFICATION

(11) **EP 0 509 148 B1**
(45) Date of publication and mention of the grant of the patent: **17.07.1996**
(21) Application number: 91200873.7
(22) Date of filing: 15.04.1991
(51) Int. Cl.: G03C 1/49, G03F 3/10, G03F 9/00

(54) **Silver halide print-out material suitable as mounting aid and position proof**
Als Montagehilfsmittel und Postionierprobe geeignetes Silberhalogenid-Auskopiermaterial
Matériau à noircissement direct à base d'halogénure d'argent, approprié comme aide de montage et épreuve de positionnement

(43) Date of publication of application: 21.10.1992
(73) Proprietor: AGFA-GEVAERT naamloze vennootschap, B-2640 Mortsel (BE)
(72) Inventor: Graindourze, Marc Bernard, B-3900 Overpelt (BE); Deploige, Luc Camille, B-2600 Berchem (BE)

(56) References cited:
- EP-A- 0 447 688
- GB-A- 1 160 955
- US-A- 3 502 471

## Description

### FIELD OF THE INVENTION

The present invention relates to a photographic print-out material and more particularly to a print-out material which can serve as a position proof or a mounting aid in pre-press graphic arts.

### BACKGROUND OF THE INVENTION

In modern commercial printing text and images are assembled according to some positional instructions given by a customer, e.g. an advertising agency, or by the lay-out department of a newspaper or magazine. Text is usually generated by a typesetter and halftone images are usually provided as three or four colour separations generated by a scanner. The process of assembling all pieces of film containing images which will be carried onto the same printing plate and securing them on a so-called masking sheet that will hold them in their appropriate positions during further pre-press steps is called "stripping". The assembled masking sheet (also called mounting sheet or assembly sheet) with attached pieces of film is generally called a "flat". In the case of stripping of negative black-and-white or negative colour separation images an opaque masking sheet has to be used. On the contrary for stripping positive black-and-white or positive colour selections as it is often the case a punched transparent polymeric support like triacetate or polyethylene terephtalate has to be used as a mounting sheet and transparent tape is required to secure the film pieces on the flat.

In multicolour printing the four colour selections have to be carried over in exact register in order to obtain a final printed result showing sharp image contours with no colour shift on the edges. Therefor all the colour selections have to be assembled with exact positional congruence. A conventional way of proceeding with positive colour separations is as follows. First a flat is assembled with film pieces of the cyan selection which usually shows the most pronounced image detail. Then a second punched transparent sheet is fixed on top of the first flat and the second colour separation is positioned, the mounted cyan selection serving as a template. This procedure is repeated for the remaining colour separations. In this way four registered colour separations are obtained which are each ready for individual exposure to a printing plate or to some intermediate duplicating material. However this conventional procedure shows some disadvantages which can endanger exact positioning. By the presence of the second transparent mounting sheet a possible parallax failure can cause a deviation from exact positioning ; furthermore the registration of a positive image on another positive is more difficult to achieve than the registration of a positive-negative image pair.

Usually when the flat of a black-and-white job or the first flat of a multicolor job has been prepared a position proof is made before proceeding with the job. The function of proofing is to check for image location and general quality, because it is often difficult to interpret the image on the flat, especially when the image is a negative. Both printer and printing customers are distracted by such things as the mounting sheet, tapes, calibration marks, notations and instructions. Moreover it is not possible to fold a flat to check for accuracy of image position in case of a so-called work and turn or signature job. By means of the proof the customer's final approval to proceed with the job can be obtained or the need for corrections can be recognized in time. Press proofs are made using the same types of ink and paper that are to be used on the final job but they show the disadvantage of being time consuming and expensive. On the contrary so-called single colour photomechanical proofing materials are much more convenient and less expensive. They do not show the actual ink colour of the final press run but this is unimportant in mere position proofing. Three common types of materials for single colour proofs are blueprint papers, diazo materials and so-called instant image proof materials.

The process of blueprinting was discovered already in 1842 by Herschel and has continued to the present time with relatively few changes. It is based on the reduction of an organic ferric salt like ferric oxalate under the action of light and the subsequent formation of Prussian blue by the action of ferricyanide, which makes the process rather unecological by modern standards. The process is negative-positive working. Unfortunately blueprint paper is not dimensionally stable and the image tends to fade with age. In practice the use of the system is restricted to the reproduction of line originals, e.g. architectural or engineering drawings.

Much more popular for the proofing of stripped photographic images are the diazo materials which are positive-positive or negative-negative working. Because they are very insensitive they have to be exposed by sources with a large UV-output. A much more serious disadvantage is the fact that the exposed material has to be developed with a special liquid or gas, generally ammonia fumes, which makes the system unfavourable from an ecological point of view.

Examples of instant image proof materials which are widely used are DYLUX 503A and 535 Instant Proof Papers (registered trade marks), marketed by DU PONT Co, which form a blue or dark gray image without chemical processing upon exposure through the original by ultraviolet radiation. Afterwards the non-image areas are fixed or deactivated by means of a uniform exposure with bright white light. The system is based on photolytic decomposition of bis-imidazole compounds to imidazole radicals which transform a leuko-dye to a dye. In its usual application the system is positive-negative working but it can be made positive-positive or negative-negative working by interchanging the sequence of UV and white light exposures.

When the instant image material is coated on a transparent base it can be used, apart from its function as position proof, as a mounting aid for stripping colour separations. So, for example, a proof can be made from e.g. a cyan selection flat on DYLUX 608A Registration Master Film (registered trade mark), a material coated on transparent CRONAR base; this proof can serve as a template for positioning the remaining colour selections. If wanted each remaining selection can be mounted directly on a separate DYLUX cyan selection proof without the use of an extra transparent mounting sheet. In this way the stripped selection can be exposed by UV radiation, adhering to the proof, to a duplicating material or to a printing plate; the adhering proof does not disturb this process because of its uniform UV density. In this way the danger for a parallax failure present when stripping conventionally on an extra transparent sheet is avoided. As a disadvantage the exposure time has to be increased. However the DYLUX materials materials show some disadvantages, like a rather high price especially for the version on transparent base, a persistent odour, and some background staining after prolonged conservation outside the dark.

From the description of the drawbacks of the prior art it is clear that there is still a need for an alternative simple and inexpensive photosensitive material which can serve as a position proofing material and/or as a mounting aid.

It is an object of the present invention to provide a simple photographic material which can serve as a position proofing material for flats of stripped images.

It is a further object of the present invention to provide a photographic material which, when coated on a tranparent base, can be used as a mounting aid for stripping colour separations.

Further objects of the present invention will become clear from the description hereafter.

### SUMMARY OF THE INVENTION

The objects of the present invention are realized by providing a photographic silver halide print-out material comprising :
(1) an opaque or a transparent support, and
(2) at least one silver halide emulsion layer coated at a silver coverage, expressed as AgNO₃, between 0.25 and 2.0 g per m², and containing a halogen acceptor in a concentration of at least 1x10⁻³ mole per mole of silver halide, the said silver halide emulsion having :
   (a) a chloride content of at least 90 % of the total halide content,
   (b) an average grain size of less than 0.3 µm.

The silver halide emulsion grains further can contain internal electron traps, preferably in the form of a metal dopant.

The material further can contain a filter dye, present in the emulsion layer or another hydrophylic colloid layer and absorbing light in the visual part of the spectral region, or a compound absorbing in the near ultraviolet region.

Due to the unusual high concentration of the halogen acceptor a print-out image with a distinct differentiation between image density and background density is obtained. Thanks further to the material design characteristics this differentiation remains stable for a sufficient long time to allow the use of this print-out image as a position proof and/or as an assembly aid when coated on a transparent base. This will be further explained in detail in the following description.

### DETAILED DESCRIPTION OF THE INVENTION

The success of this new application of the long known print-out effect in the field of image assembly and position proofing depends on the realization of a clear visual distinction between the outlook of the unprocessed silver halide in the unexposed areas and the density of photolytic silver in those areas where the print-out material is maximally exposed by UV light through the most transparent parts of the stripped original. This visual distinction must remain for a sufficiently long time in order to allow the proof to be inspected, in case of the position proofing, or the stripping jobs to be finished in case of use as registration master. In practice this distinction should last for at least a few hours and preferably at least one working day.

The well-known print-out phenomenon can be generally described as the darkening of photographic emulsions under the influence of extended exposure to ambient light or a short exposure to an intense light source. Scientific reports on the print-out effect have been published in e.g. J. Photogr. Sci., Vol. 6, p. 141 (1958), J. Opt. Soc. Am., Vol. 28, p. 431 (1938), J. Chem. Phys., Vol. 18, p. 499 (1950), J. Opt. Soc. Am., Vol. 23, p. 157 (1933) and ibid., Vol. 26, p. 347 (1936). X-ray or electron diffraction demonstrate that silver metal is formed; so the print-out effect can be conceived as a latent image photolytically grown to visible dimensions. Analytical techniques show the release of halogen; so it is no wonder that so-called halogen acceptors can enhance the print-out effect. Suitable halogen acceptors which promote the print-out effect are disclosed e.g. in US 2,369,449, US 3,287,137, US 3,364,032, US 3,447,927 and US 3,458,317. Some kinds of high speed oscillographic recording materials make use of the print-out effect. Suitable halogen acceptors for this kind of application are e.g. perhydro-1,2,4-triazine-5-one-3-thione derivatives disclosed in US 3,502,471.

In the practical use of the material of this invention a common UV source is used to contactexpose the print-out material through the stripped original . Metal-halogen lamps, mercury vapour sources and quartz-halogen sources can be used or other types of UV sources which are commonly available in a pre-press department. With the material according to the invention a distinct print-out image is obtained immediately. No kind of processing or further treatment is necessary which makes the system user-friendly and ecologically favourable. During successive exposure in ambient office light, the print out density still grows somewhat but reaches a maximal value after some time; on the other hand the background density starts to increase after a while due to formation of photolytic silver in the unexposed areas too. The material becomes unsuitable for use when the difference between background and image density becomes too low or, in the case of use as mounting aid, the transparency of the unexposed areas becomes too low to allow practical work on a assembly light-table. It is the task of the emulsion technologist to realize the best compromise between a sufficient density difference and a sufficiently long stability under office light conditions. This compromise can be influenced by different parameters known in the art.

The photographic print-out element of the present invention can be composed of one single emulsion layer or it can be built up by two or even more emulsion layers. Beside the light sensitive emulsion layer(s) the photographic material can contain several non-light sensitive layers, e.g. a protective layer, one or more backing layers, one or more subbing layers, and one or more intermediate layers e.g. filter layers. In a preferred embodiment of this invention the material is simply composed of a support, a subbing layer, one emulsion layer and a protective layer. In the case of a paper support the emulsion can be coated on both sides for a particular application as will be explained later.

For the practice of the present invention an unusual low silver coverage of the coated emulsion layer is a necessity. Because of light absorption and diffusion in silver halide too high a coverage will lead immediately to too high a background density which, in the case of a transparent base, will make the print-out image unsuitable for assembly purposes because of an insufficient transparency of this background. Moreover the background density will grow too fast under office light conditions to an inacceptable level because of the subsequent formation of photolytic silver in those unexposed areas. For these reasons the silver coverage, expressed as AgNO₃/m², is comprised according to this invention between 0.25 and 2.0 g/m² and preferably between 0.40 and 1.0 g/m².

The silver halide emulsion has a fine average grain size in the practice of this invention which leads to an improved stability under office light. Moreover a fine grain emulsion coated on a transparent base will look more transparent on a light table thanks to low light scattering compared to a medium or coarse grain emulsion, which is important in the application as registration aid. Therefor in the present invention the average grain size is restricted to values below 0.3 micron. Preferably the average grain size is even lower then 0.15 µm.

Because of the demand for a sufficiently long stability of the image-wise exposed material under ambient light conditions the emulsion should be as insensitive as possible to visible light. This can be achieved by an emulsion rich in chloride, the spectral sensivity distribution of which is situated principally in the ultraviolet region. Therefor according to the present invention a chloride content of at least 90 mole % is required and preferably the emulsion consists of about 100 % of chloride. Of course preferably no spectral sensitizer is present.

In order to further improve the stability for room light a filter dye absorbing in the visible spectral region, preferably in the region between 400 and 450 nm, or a compound absorbing in the near ultraviolet region (350 - 400 nm) can be present in the photographic material. The chemical nature of the filter dye is not limited in the practice of this invention. Suitable light-absorbing dyes are described in e.g. US 4,092,168, US 4,311,787, DE 2,453,217, and GB 7,907,440. The filter dye can be present in the emulsion layer itself but preferably the dye is present in another hydrophilic layer situated farther from the support than the emulsion layer, e.g. in the protective layer. Because there is no processing step the dye may be diffusable or not. It can be incorporated in the form of a solution or as a dispersion. Examples of preferred filter dyes are listed below :

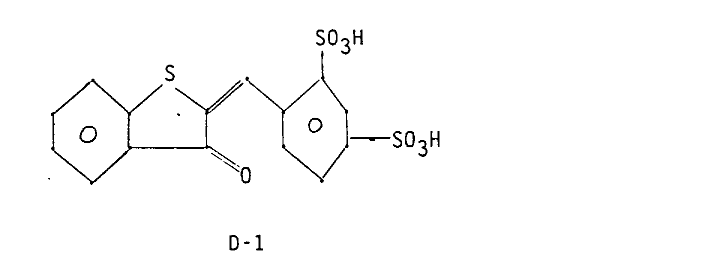

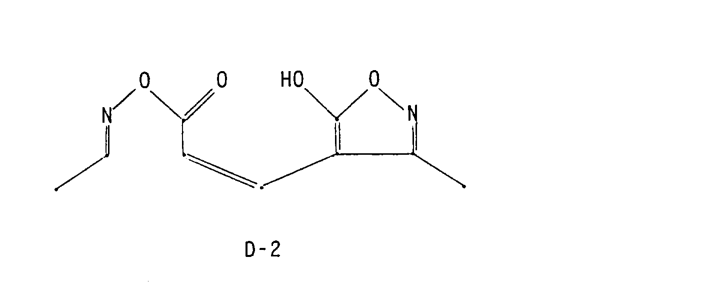

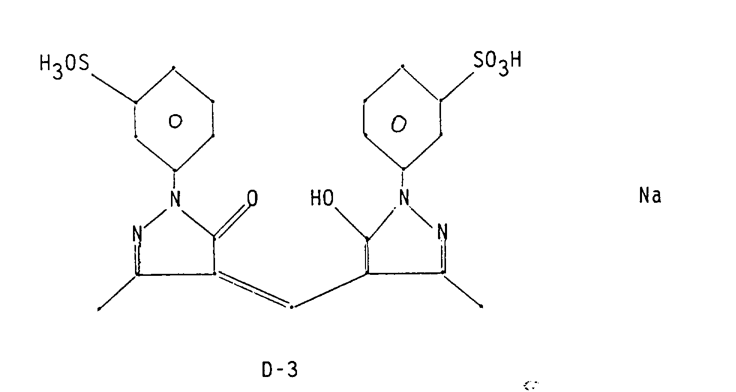

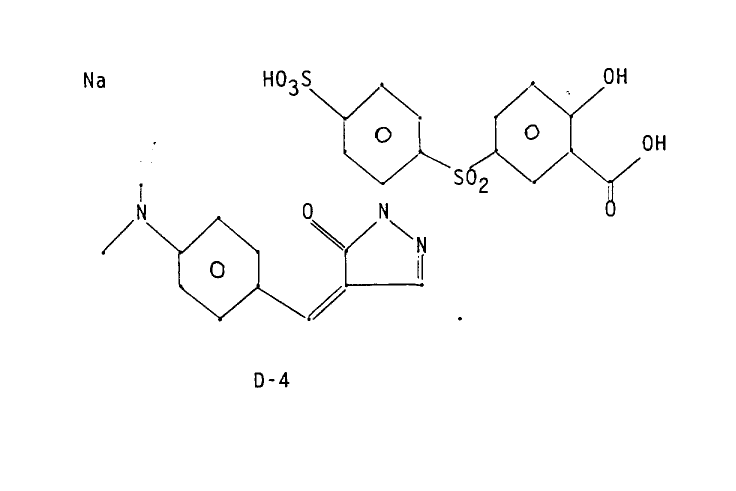

An example of a preferred UV-absorber is :

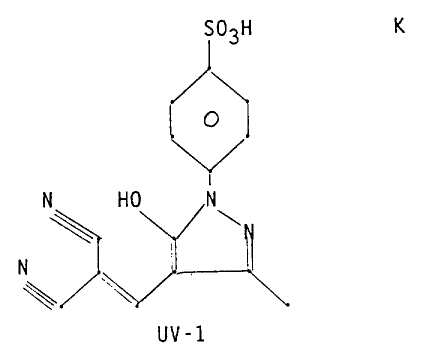

The filter dye, which may be combined with another supplemental dye can perform other functions. The visual contrast can be enhanced; for instance, when the print-out image is black or grey, a yellowish dye gives an enhancement of the visual contrast. It can act as a "recognition dye" in order to distinguish the print-out material from other photographic materials commonly used in pre-press activity such as scan and duplicating materials. It is even thinkable to design different print-out materials with different colour hues according to the nature of the colour separation which has to be proofed by or stripped on the print-out material, e.g. a magenta hue for proofing or stripping the magenta selection, a yellow hue for the yellow selection etc.

A further extension of the usable life time of the print out-image can of coarse be obtained by the user by working under office light poor in UV content or by mounting UV absorbing sleeves around the office light sources.

When a fine grained emulsion rich in chloride and non spectrally sensitized is exposed to UV radiation only a faint print-out image is obtained even at a strong overexposure. Only a small density difference of about 0.02 to 0.04 between background and print-out image is realized at a silver coverage of 1.0 Ag/m² expressed as AgNO₃. In order to produce a9 pronounced and relatively stable print-out image on image-wise exposure a halogen acceptor must be present in an unusual high concentration of at least 10⁻³ mole and preferably of at least 5.10⁻³ mole per mole of silver halide. In this way a difference between the background density and the print-out image density of 0.10 to 0.50, depending on efficiency and concentration of the halogen acceptor, is easily obtained which is sufficient for the applications envisaged in this invention. Suitable halogen acceptors are disclosed in the United State patents cited above. Examples of particular useful halogen acceptors include the following compounds :

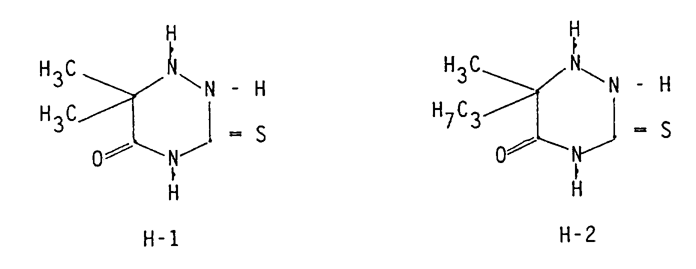

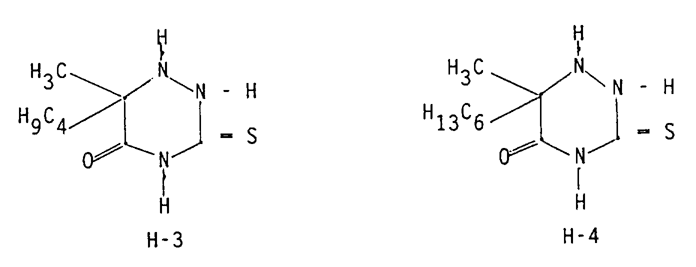

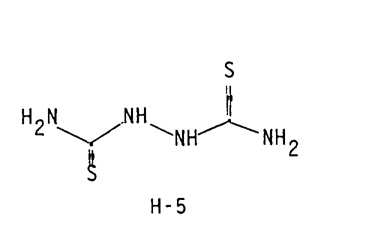

The photographic emulsions used in accordance with the present invention can be prepared from soluble silver salts and soluble halides according to different methods as described e.g. by P. Glafkides in "Chimie et Physique Photographique", Paul Montel, Paris (1967), by G.F. Duffin in "Photographic Emulsion Chemistry", The Focal Press, London (1966), and by V.L. Zelikman et al in "Making and Coating Photographic Emulsion", The Focal Press, London (1966). These preparation techniques include mixing the halide and silver solutions in partially or fully controlled conditions of temperature, concentrations, sequence of addition, and rates of addition. The silver halide can be precipitated according to the single-jet method, the double-jet method, or the conversion method.

Two or more types of silver halide emulsions that have been prepared differently can be mixed for forming a photographic emulsion for use in accordance with the present invention.

The size distribution of the silver halide particles of the photographic emulsions to be used in connection with the present invention can be homodisperse or heterodisperse.

The light-sensitive silver halide emulsion can be a negative or a direct positive working emulsion. However in both cases a negative print-out image is obtained. The emulsion can be a so-called primitive emulsion, in other words an emulsion that has not been chemically sensitized or it can be chemically sensitized as described e.g. in the above-mentioned "Chimie et Physique Photographique" by P. Glafkides, in the above-mentioned "Photographic Emulsion Chemistry" by G.F. Duffin, in the above-mentioned "Making and Coating Photographic Emulsion" by V.L. Zelikman et al, and in "Die Grundlagen der Photographischen Prozesse mit Silberhalogeniden" edited by H. Frieser and published by Akademische Verlagsgesellschaft (1968). As described in said literature chemical sensitization can be carried out by effecting the ripening in the presence of small amounts of compounds containing sulphur e.g. thiosulphate, thiocyanate, thioureas, sulphites, mercapto compounds, and rhodamines. The emulsions can be sensitized also by means of gold-sulphur ripeners or by means of reductors e.g. tin compounds as described in GB 789,823, amines, hydrazine derivatives, formamidine-sulphinic acids, and silane compounds.

The emulsions providing the print-out image can contain internal electron traps. Internal electron trapping systems are described e.g. in "Chimie et Physique Photographique" by G.F. Glafkides, in "Making and Coating Photographic Emulsions" by V.L. Zelikman et al., and in "Die Grundlagen des Photographischen Prozesses mit Silberhalogeniden" edited by H. Frieser and published by Akademische Verlaggeselschaft (1968). As described in said literature internal electron trapping systems can be obtained by the presence of phase bounderies in the so-called core-shell emulsion type, whereby the core can be chemically ripened if wanted. The core and the shell may have different halide compositions and contain different dopants. Beside having a different core and shell the silver halide grains may comprise different phases in between. Metal dopants such as Pb, Cd, Hg, Pd, Tl, Ru, Rh, Ir, Bi and Cu can function as well as internal electron traps in the interior of the silver halide crystals. The choice of the metal dopant can play an important role in the colour characteristics of the print-out image. For example a rhodium dopant will produce a black print-out image while the colour obtained with a copper dopant or with no metal dopant at all is redbrownish. This provides a method of producing print-out images with different colours as an alternative to producing varying background colour hues by incorporating different colour absorbing dyes as explained above.

The above described ingredients are preferable for a successful application of the present invention. However other common additives well known in the photographic art can be present in the coated emulsion layer or in another hydrophylic layer and can influence the print-out properties. So, for example, in a preferred embodiment of the present invention, the addition of a developing agent to the emulsion layer or an adjacent colloid layer can enhance the growth of the density difference between print-out image and background under office light.

A so-called stabilizer can be present in the coated emulsion and influence the relative stability of print-out image and background density. Suitable examples are e.g. the heterocyclic nitrogen-containing compounds such as benzothiazolium salts, nitroimidazoles, nitrobenzimidazoles, chlorobenzimidazoles, bromobenzimidazoles, mercaptothiazoles, mercaptobenzothiazoles, mercaptobenzimidazoles, mercaptothiadiazoles, aminotriazoles, benzotriazoles (preferably 5-methyl-benzotriazole), nitrobenzotriazoles, mercaptotetrazoles, in particular 1-phenyl-5-mercapto-tetrazole, mercaptopyrimidines, mercaptotriazines, benzothiazoline-2-thione, oxazoline-thione, triazaindenes, tetrazaindenes and pentazaindenes, especially those described by Birr in Z. Wiss. Phot. 47 (1952), pages 2-58, triazolopyrimidines such as those described in GB 1,203,757, GB 1,209,146, JA-Appl. 75-39537, and GB 1,500,278, and 7-hydroxy-s-triazolo-[1,5-a]-pyrimidines as described in US 4,727,017, and other compounds such as benzenethiosulphonic acid, toluenethiosulphonic acid, benzenethiosulphinic acid and benzenethiosulphonic acid amide. A revue of useful compounds is published in Research Disclosure N° 17643 (1978), Chapter VI.

Besides the silver halide another essential component of a light-sensitive emulsion layer is the binder. The binder is a hydrophilic colloid, preferably gelatin. Gelatin can, however, be replaced in part or integrallly by synthetic, semi-synthetic, or natural polymers. The gelatin can be lime-treated or acid-treated gelatin. The preparation of such gelatin types has been described in e.g. "The Science and Technology of Gelatin", edited by A.G. Ward and A. Courts, Academic Press 1977, page 295 and next pages. The gelatin can also be an enzyme-treated gelatin as described in Bull. Soc. Sci. Phot. Japan, N° 16, page 30 (1966).

The binder of the photographic element, especially when the binder used is gelatin, can be hardened with appropriate hardening agents such as those of the epoxide type, those of the ethylenimine type, those of the vinylsulfone type e.g. 1,3-vinylsulphonyl-2-propanol, chromium salts e.g. chromium acetate and chromium alum, aldehydes e.g. formaldehyde, glyoxal, and glutaraldehyde, N-methylol compounds e.g. dimethylolurea and methyloldimethylhydantoin, dioxan derivatives e.g. 2,3-dihydroxy-dioxan, active vinyl compounds e.g. 1,3,5-triacryloyl-hexahydro-s-triazine, active halogen compounds e.g. 2,4-dichloro-6-hydroxy-s-triazine, and mucohalogenic acids e.g. mucochloric acid and mucophenoxychloric acid. These hardeners can be used alone or in combination. The binders can also be hardened with fast-reacting hardeners such as carbamoylpyridinium salts as disclosed in US 4,063,952.

The photographic element of the present invention may further comprise various kinds of surface-active agents in the photographic emulsion layer or in at least one other hydrophilic colloid layer. Suitable surface-active agents include non-ionic agents such as saponins, alkylene oxides e.g. polyethylene glycol, polyethylene glycol /polypropylene glycol condensation products, polyethylene glycol alkyl ethers or polyethylene glycol alkylaryl ethers, polyethylene glycol esters, polyethylene glycol sorbitan esters, polyalkylene glycol alkylamines or alkylamides, silicone-polyethylene oxide adducts, glycidol derivatives, fatty acid esters of polyhydric alcohols and alkyl esters of saccharides; anionic agents comprising an acid group such as a carboxy, sulpho, phospho, sulphuric or phosphoric ester group; ampholytic agents such as aminoacids, aminoalkyl sulphonic acids, aminoalkyl sulphates or phosphates, alkyl betaines, and amine-N-oxides; and cationic agents such as alkylamine salts, aliphatic, aromatic, or heterocyclic quaternary ammonium salts, aliphatic or heterocyclic ring-containing phosphonium or sulphonium salts. Such surface-active agents can be used for various purposes e.g. as coating aids, as compounds preventing electric charges, as compounds improving slidability, as compounds facilitating dispersive emulsification, as compounds preventing or reducing adhesion. In some instances a slight but distinct favourable effect can be noticed from the kind of wetting agent on the stability of the background density under white light, as will be illustrated by an example.

The photographic element of the present invention may further comprise various other additives such as e.g. compounds improving the dimensional stability of the photographic element, antistatic agents, spacing agents and plasticizers.

Antistatic agents can be used in one or more of the layers on the emulsion side or in a backing layer.

Suitable additives for improving the dimensional stability of the photographic element are e.g. dispersions of a water-soluble or hardly soluble synthetic polymer e.g. polymers of alkyl(meth)acrylates, alkoxy(meth)acrylates, glycidyl (meth)acrylates, (meth)acrylamides, vinyl esters, acrylonitriles, olefins, and styrenes, or copolymers of the above with acrylic acids, methacrylic acids, Alpha-Beta-unsaturated dicarboxylic acids, hydroxyalkyl (meth)acrylates, sulphoalkyl (meth)acrylates, and styrene sulphonic acids. The presence of these compounds can minimize the amount of binder needed per square meter in order the minimize the curl when using no compensating backing layers.

Spacing agents can be present of which, in general, the average particle size is comprised between 0.2 and 10 µm. Suitable spacing agents can be made e.g. of polymethyl methacrylate, of copolymers of acrylic acid and methyl methacrylate, and of hydroxypropylmethyl cellulose hexahydrophthalate. Other suitable spacing agents have been described in US 4,614,708. Spacing agents can also serve as matting agents.

The choice of the support of the print-out material of the invention depends on the application envisaged. For position proofing an opaque support, preferably a paper support, is recommended. This paper support can be provided with a polyalkylene layer, e.g. a polyethylene layer, and/or a subbing layer. The quality demands on the paper support are relatively low compared to e.g. paper bases for phototypesetting materials. The paper is preferably very easy to fold. In a particular embodiment the base is coated on both side with emulsion. In this way different print-out images can be obtained on both side of the support which offers the possibility to control the position of images on different pages in the folded form.

It is also possible to vary the print-out density by varying the UV exposure level. In this way two or more different images can be exposed successively on one print-out material sheet and differentiated from each other by their respective print-out densities. These two images can be e.g. information from two colour selections, or two different parts of one original e.g. a text part and a flat colour part.

In the case of application as assembly aid the print-out material of the present invention has to be coated on a transparent base. Preferably an organic resin support is used, e.g. cellulose nitrate film, cellulose acetate film, polyvinylacetal film, polystyrene film, polyethylene terephthalate film, polycarbonate film, polyvinylchloride film or poly-Alpha-olefin films such as polyethylene or polypropylene film. The thickness of such organic resin film is preferably comprised between 0.07 and 0.35 mm. These organic resin supports are preferably coated with a subbing layer. For a particular embodiment of the mounting aid application the subbing layer is a rather loosely adhering layer (a "stripping layer") so that the support can be easily stripped off. In this special application a first colour separation e.g. cyan is exposed to the print-out material as usual. This exposed material is then laid with the print-out image side down on the light-table. The mounting of a second selection is then performed on the backside of the transparent support. Finally the print-out image and the mounted selection are separated by peeling-off the special strippable subbing layer. In this way the print-out material does not need to stay adhered to the mounted selection while exposing the latter to a printing plate or duplicating film shortening the exposure time in this way.

The following examples illustrate the invention without limiting it thereto.

### EXAMPLES

The examples elucidate the parameters of importance for the composition of the material according to the invention. All the examples have been carried out with pure silver chloride emulsions prepared by a conventional double jet precipitation technique. By varying the precipitation conditions emulsions with different average grain sizes were obtained. However unless otherwise denoted in a particular example a cubical emulsion having an average grain size of 0.17 µm and doped with 10⁻⁴ mole of Rhodium per mole silver chloride was used. A chemical ripening was performed using 2x10⁻⁵ mole of sodium thiosulphate and 2.5x10⁻⁶ mole of chloroauric acid per mole silver chloride.

Unless otherwise denoted in a specific example the silver halide was coated on a polyethylene terephtalate support at a coverage of 1 g Ag/m², expressed as AgNO₃ with a protective layer containing spacing agents on top of it. Conventional coating aids were used.

The coated emulsions were exposed through a black-and-white original on the graphic arts exposure unit PRINTON DL1000, marketed by AGFA-GEVAERT N.V., using a 1000 Watt high pressure metal-halogen lamp.

The white light stability was tested on a mounting table (TL-tubes, 2500 lux) or under office light conditions (TL-tubes, 250 lux). No filters or sleeves to cut off UV radiation were used.

The density measurements in case of the examples on a transparent support were carried out on a screen DM-500 densitometer (transmission densities); in case of an opaque support they were carried out on a MACBETH RO 514 densitometer (reflection densities).

### EXAMPLE 1

### Example 1a

In this example the coverage of the coated silver halide and the amount of halogen accepting compound H-4 were varied (table 1) :

**TABLE 1**

| g AgNO₃ /m² | conc. H-4 (1) | normal (2) | | | white light stab. (3) | | |
|---|---|---|---|---|---|---|---|
| | | Db.gr.(4) | Dpr.o.(5) | ΔD | Db.gr. | D.pr.o. | ΔD |
| 1 | - | 0.14 | 0.16 | 0.02 | 0.14 | 0.16 | 0.02 |
| 2 | - | 0.20 | 0.24 | 0.04 | 0.21 | 0.25 | 0.04 |
| 0.2 | 2.1×10⁻² | 0.07 | 0.12 | 0.05 | 0.08 | 0.13 | 0.05 |
| 0.5 | 2.1×10⁻² | 0.10 | 0.21 | 0.11 | 0.12 | 0.23 | 0.11 |
| 1 | 2.1×10⁻² | 0.14 | 0.39 | 0.25 | 0.20 | 0.42 | 0.22 |
| 2 | 2.1×10⁻² | 0.20 | 0.57 | 0.37 | 0.30 | 0.62 | 0.32 |
| 1 | 7.0×10⁻⁴ | 0.14 | 0.18 | 0.04 | 0.18 | 0.20 | 0.02 |
| 1 | 2.1×10⁻³ | 0.14 | 0.24 | 0.10 | 0.18 | 0.25 | 0.07 |
| 1 | 1.05×10⁻² | 0.14 | 0.29 | 0.15 | 0.18 | 0.31 | 0.13 |
| 1 | 5.3×10⁻² | 0.14 | 0.39 | 0.25 | 0.19 | 0.45 | 0.26 |

| | | | | | | | |
|---|---|---|---|---|---|---|---|
| Notes : (1) mole/mole of AgCl | | | | | | | |
| (2) immediately after exposure | | | | | | | |
| (3) after 4 hours exposure under office light (TL-tubes, 250 lux) | | | | | | | |
| (4) background density | | | | | | | |
| (5) maximal print-out density | | | | | | | |

Table 1 clearly demonstrates that the use of too low a silver coverage or too low an amount of halogen-acceptor gives rise to ΔD values which are unpracticle for use of the print-out image as a mounting aid.

### Example 1b.

In this example the average grain size of the silver chloride emulsion was 0.08 µm. The halogen acceptor when used was compound H-4 in a concentration of 2.1x10⁻² mole per mole of silver chloride. The metal dopant was varied according to table 2.

**TABLE 2**

| metal dopant | | presence of H-4 | Db.gr. | Dpr.o. | ΔD | image colour |
|---|---|---|---|---|---|---|
| metal | conc.(1) | | | | | |
| - | - | No | 0.05 | 0.07 | 0.02 | redbrown |
| Cu | 2×10⁻³ | No | 0.05 | 0.08 | 0.03 | redbrown |
| - | - | Yes | 0.05 | 0.16 | 0.11 | redbrown |
| Cu | 2×10⁻³ | Yes | 0.06 | 0.18 | 0.12 | redbrown |
| Rh | 1×10⁻⁵ | Yes | 0.05 | 0.18 | 0.13 | greybrown |
| Rh | 1×10⁻⁴ | Yes | 0.06 | 0.23 | 0.17 | black |

| | | | | | | |
|---|---|---|---|---|---|---|
| note : (1) mole per mole AgCl | | | | | | |

This example demonstrates that the presence of an halogen-acceptor is indispensable for obtaining a sufficient density difference. The example further demonstrates that the nature of the metal dopant can change the print-out image colour which can be important for both mounting aid as position proof applications.

### Example 1c

The average grain size d was varied according to table 3. Halogen-acceptor H-4 was used in an amount of 1.05x10⁻² mole per mole silver chloride.

**TABLE 3**

| d | Db.gr. | Dpr.o. | ΔD |
|---|---|---|---|
| 0.34 µm | 0.22 | 0.40 | 0.18 |
| 0.17 µm | 0.12 | 0.29 | 0.17 |
| 0.08 µm | 0.06 | 0.23 | 0.17 |

This example demonstrates the correlation between the background density of the print-out image and the average grain size of the silver halide particles. For application as mounting aid or position proof the Db.gr. becomes too high for d > 0.3 µm; preferably d is lower then 0.15 micron as is clearly demonstrated by this example.

### Example 1d

In this example the average grain size of the emulsion particles was 0.08 micron. Halogen acceptors H-4 and H-5 were used in amounts according to table 4.

**TABLE 4**

| halogen-acceptor | | (2) | | | (3) | | | (4) | | |
|---|---|---|---|---|---|---|---|---|---|---|
| No | amount | Db.gr. | Dpr.o | ΔD | Db.gr. | Dpr.o | ΔD | Db.gr. | Dpr.o | ΔD |
| H-4 | 1.05×10⁻² | 0.06 | 0.19 | 0.13 | 0.12 | 0.26 | 0.14 | 0.21 | 0.32 | 0.11 |
| H-4 | 2.1×10⁻² | 0.06 | 0.27 | 0.21 | 0.16 | 0.40 | 0.34 | 0.29 | 0.45 | 0.16 |
| H-5 | 3.7×10⁻² | 0.06 | 0.32 | 0.26 | 0.12 | 0.54 | 0.42 | 0.20 | 0.66 | 0.46 |
| notes :(1) mole per mole of silver chloride; | | | | | | | | | | |

| | | | | | | | | | | |
|---|---|---|---|---|---|---|---|---|---|---|
| (2) immediately after image-wise exposure; | | | | | | | | | | |
| (3) after 1 hour illumination on a mounting table in a normal office environment; | | | | | | | | | | |
| (4) same as (3) but after 2 hours. | | | | | | | | | | |

This example illustrates that a satisfactory print-out image can be obtained with halogen-acceptors of widely different chemical nature.

### Example 1e

The emulsion layer contained silver chloride particles of 0.08 µm average grain size. A developing agent could be present according to table 5. Halogen-acceptor H-4 was used in an amount of 2.1x10⁻² mole per mole of silver chloride.

**TABLE 5**

| Devel. agent, | conc. (1) | (2) | | | (3) | | |
|---|---|---|---|---|---|---|---|
| | | Db.gr. | Dpr.o. | ΔD | Db.gr. | Dpr.o. | ΔD |
| - | - | 0.06 | 0.27 | 0.21 | 0.14 | 0.39 | 0.25 |
| hydroquinone, | 0.23 | 0.06 | 0.30 | 0.24 | 0.18 | 0.53 | 0.35 |
| hydroquinone, | 0.46 | 0.06 | 0.29 | 0.23 | 0.20 | 0.58 | 0.38 |
| Resorcinol, | 0.85 | 0.06 | 0.26 | 0.20 | 0.11 | 0.44 | 0.33 |
| Notes : | | | | | | | |

| | | | | | | | |
|---|---|---|---|---|---|---|---|
| (1) mole per mole of silver chloride; | | | | | | | |
| (2) immediately after image-wise exposure; | | | | | | | |
| (3) after 1 hour illumination on a mounting table (TL-tubes, 2500 lux) in a normal office environment. | | | | | | | |

This example shows the effect of the addition of a developing agent on the density difference in the print-out image. It shows that the usefulness of the print-out image as mounting aid or position proof can be improved or extended in time under white light conditions.

### EXAMPLE 2

In this example the protective layer contains a dye or UV-absorber showing a wavelength of maximal absorption according to table 6. Halogen-acceptor H-4 is used in amount of 1x10⁻² mole per mole of silver chloride.

**TABLE 6**

| Dye | visual contrast (1) | | (2) | | | (3) | | |
|---|---|---|---|---|---|---|---|---|
| wav. max | colour | | Db.gr. | Dpr.o. | ΔD | Db.gr. | Dpr.o. | ΔD |
| - | - | 3 | 0.14 | 0.29 | 0.15 | 0.21 | 0.35 | 0.15 |
| 390 nm | light yellow | 2 | 0.14 | 0.25 | 0.11 | 0.16 | 0.30 | 0.14 |
| 420 nm | yellow | 4 | 0.14 | 0.26 | 0.12 | 0.15 | 0.29 | 0.14 |
| 440 nm | yellow | 5 | 0.15 | 0.27 | 0.12 | 0.16 | 0.32 | 0.16 |
| 490 nm | orange | 3 | 0.19 | 0.33 | 0.14 | 0.21 | 0.39 | 0.16 |
| 550 nm | cyan | 4 | 0.20 | 0.34 | 0.14 | 0.23 | 0.40 | 0.17 |

| | | | | | | | | |
|---|---|---|---|---|---|---|---|---|
| notes : (1) in an arbitrary quality rating scale ranging from 0 (the worse) to 5 (the best) the comparison is set to 3; | | | | | | | | |
| (2) immediately after image-wise exposure; | | | | | | | | |
| (3) after 4 hours illumination in office light conditions (TL-tubes, 250 lux). | | | | | | | | |

This example shows how the presence of a dye can enhance the visual contrast between background and print-out image. Furtheron it illustrates the influence of an UV-absorber or dye on the stability under white light conditions, especially on the growth of the background density.

### EXAMPLE 3

The emulsion layer was coated on one hand on a polyethylene terephtalate support (PET) like in the previous examples and on the other hand on a paper support covered with a thin polyethylene layer. The emulsion was composed of silver chloride with an average grain size of 0.08 mp. Halogen-acceptor H-5 was used in a concentration of 9x10⁻³ mole per mole silver chloride.

**TABLE 7**

| support | Db.gr. | Dpr.o. | ΔD | visual contrast (1) |
|---|---|---|---|---|
| PET | 0.06 | 0.16 | 0.10 | 0-2 |
| PE-paper | 0.10 | 0.52 | 0.42 | 5 |
| note : | | | | |

| | | | | |
|---|---|---|---|---|
| (1) like previous example | | | | |

The results of table 7 illustrate the increase in ΔD when changing the transparent support for a paper one. It follows that for position proofing the choice of an opaque support, e.g. a paper support should be recommended.

## Claims

1. Photographic silver halide print-out material comprising :
(1) a support, and
(2) at least one silver halide emulsion layer coated at a silver coverage, expressed as AgNO₃, between 0.25 and 2.0 g per m², and containing a halogen acceptor in a concentration of at least 1x10⁻³ mole per mole of silver halide, the said silver halide emulsion having:
(a) a chloride content of at least 90 % of the total halide content,
(b) an average grain size of less than 0.3 µm.

2. Photographic silver halide print-out material according to claim 1 wherein said silver halide emulsion further contains internal electron traps.

3. Photographic silver halide print-out material according to claim 1 or 2 wherein said internal electron traps are formed by a metal dopant.

4. Photographic silver halide print-out material according to any of claims 1 to 3 wherein said silver halide emulsion layer further contains a dye absorbing in the visual spectral region.

5. Photographic silver halide print-out material according to claim 4 wherein said dye is a filter dye absorbing principally between 400 and 450 nm.

6. Photographic silver halide print-out material according to any of claims 1 to 5 wherein said silver halide emulsion layer further contains a UV-absorber.

7. Photographic silver halide print-out material according to any of claims 1 to 6 wherein said silver coverage, expressed as AgNO₃, is comprised between 0.40 and 1.0 g per m².

8. Photographic silver halide print-out material according to any of claims 1 to 7 wherein said average grain size of the emulsion is less than 0.15 µm.

9. Photographic silver halide print-out material according to any of claims 1 to 8 wherein said halogen acceptor is present in a concentration of at least 5.10⁻³ mole per mole silver halide.

10. Photographic silver halide print-out material according to any of claims 1 to 9 wherein said wherein said material further contains a developing agent.

11. Photographic silver halide print-out material according to any of claims 1 to 10 wherein said support is an opaque support.

12. Photographic silver halide print-out material according to claim 11 wherein said support is a paper support.

13. Use of a photographic silver halide print-out material according to claims 11 or 12 as a position proof after image-wise exposure to ultraviolet radiation.

14. Photographic silver halide print-out material according to any of claims 1 to 10 wherein said support is a transparent support.

15. Photographic silver halide print-out material according to claim 14 wherein said transparent support is coated with a strippable subbing layer.

16. Use of a silver halide print-out material according to claim 14 or 15 as a mounting aid after image-wise exposure to ultraviolet radiation.

17. Use of a silver halide print-out material according to claim 14 or 15 as a position proof after image-wise exposure to ultraviolet radiation.

## Patentansprüche

1. Photographisches, die nachstehenden Bestandteile enthaltendes Silberhalogenid-Auskopiermaterial:
(1) einen Träger, und
(2) wenigstens eine Silberhalogenidemulsionsschicht, die in einem Verhältnis von zwischen 0,25 und 2,0 g Silber/m², ausgedrückt als AgNO₃, aufgetragen ist, und einen Halogenakzeptor in einem Verhältnis von wenigstens 1x10⁻³ Mol pro Mol Silberhalogenid enthält, wobei die Silberhalogenidemulsion :
(a) einen Chloridgehalt von wenigstens 90% des Gesamthalogenidgehalts, und
(b) eine durchschnittliche Korngröße von weniger als 0,3 µm aufweist.

2. Photographisches Silberhalogenid-Auskopiermaterial nach Anspruch 1, dadurch gekennzeichnet, daß die Silberhalogenidemulsion weiterhin Innenelektronenfallen enthält.

3. Photographisches Silberhalogenid-Auskopiermaterial nach Anspruch 1 oder 2, dadurch gekennzeichnet, daß die Innenelektronenfallen durch einen Metalldotierstoff gebildet werden.

4. Photographisches Silberhalogenid-Auskopiermaterial nach irgendeinem der Ansprüche 1 bis 3, dadurch gekennzeichnet, daß die Silberhalogenidemulsionsschicht weiterhin einen im visuellen Spektralbereich absorbierenden Farbstoff enthält.

5. Photographisches Silberhalogenid-Auskopiermaterial nach Anspruch 4, dadurch gekennzeichnet, daß der Farbstoff ein hauptsächlich zwischen 400 und 450 nm absorbierender Filterfarbstoff ist.

6. Photographisches Silberhalogenid-Auskopiermaterial nach irgendeinem der Ansprüche 1 bis 5, dadurch gekennzeichnet, daß die Silberhalogenidemulsionsschicht weiterhin ein UV-Absorptionsmittel enthält.

7. Photographisches Silberhalogenid-Auskopiermaterial nach irgendeinem der Ansprüche 1 bis 6, dadurch gekennzeichnet, daß das Verhältnis von als AgNO₃ ausgedrücktem Silber zwischen 0,40 und 1,0 gpro m² liegt.

8. Photographisches Silberhalogenid-Auskopiermaterial nach irgendeinem der Ansprüche 1 bis 7, dadurch gekennzeichnet, daß die durchschnittliche Korngröße der Emulsion weniger als 0,15 µm beträgt.

9. Photographisches Silberhalogenid-Auskopiermaterial nach irgendeinem der Ansprüche 1 bis 8, dadurch gekennzeichnet, daß der Halogenakzeptor in einem Verhältnis von wenigstens 5,10⁻³ Mol pro Mol Silberchlorid enthalten ist.

10. Photographisches Silberhalogenid-Auskopiermaterial nach irgendeinem der Ansprüche 1 bis 9, dadurch gekennzeichnet, daß das Material weiterhin einen Entwickler enthält.

11. Photographisches Silberhalogenid-Auskopiermaterial nach irgendeinem der Ansprüche 1 bis 10, dadurch gekennzeichnet, daß der Träger ein opaker Träger ist.

12. Photographisches Silberhalogenid-Auskopiermaterial nach Anspruch 11, dadurch gekennzeichnet, daß der Träger ein Papierträger ist.

13. Gebrauch eines photographischen Silberhalogenid-Auskopiermaterials nach Anspruch 11 oder 12 als Positionierprobe nach der bildmäßigen Belichtung mit Ultraviolettstrahlung.

14. Photographisches Silberhalogenid-Auskopiermaterial nach irgendeinem der Ansprüche 1 bis 10, dadurch gekennzeichnet, daß der Träger ein transparenter Träger ist.

15. Photographisches Silberhalogenid-Auskopiermaterial nach Anspruch 14, dadurch gekennzeichnet, daß der transparente Träger mit einer abziehbaren Haftschicht überzogen ist.

16. Gebrauch eines Silberhalogenid-Auskopiermaterials nach Anspruch 14 oder 15 als Montagehilfsmittel nach der bildmäßigen Belichtung mit Ultraviolettstrahlung.

17. Gebrauch eines Silberhalogenid-Auskopiermaterials nach Anspruch 14 oder 15 als Positionierprobe nach der bildmäßigen Belichtung mit Ultraviolettstrahlung.

## Revendications

1. Matériau photographique à noircissement direct à base d'halogénure d'argent comprenant:
(1) un support, et
(2) au moins une couche d'émulsion à l'halogénure d'argent coulée à un taux d'argent, exprimé comme AgNO₃, entre 0,25 et 2,0 g/m², et contenant un accepteur d'halogène dans une concentration d'au moins 1x10⁻³ moles par mole d'halogénure d'argent, laquelle émulsion à l'halogénure d'argent a:
(a) un contenu en chlorure d'au moins 90 % du contenu total en halogénure,
(b) une granularité moyenne inférieure à 0,3 µm.

2. Matériau photographique à noircissement direct à base d'halogénure d'argent selon la revendication 1, caracterisé en ce que l'émulsion à l'halogénure d'argent contient en plus des pièges à électrons internes.

3. Matériau photographique à noircissement direct à base d'halogénure d'argent selon la revendication 1 ou 2, caractérisé en ce que ces pièges à électrons internes sont formés par un dopant métallique.

4. Matériau photographique à noircissement direct à base d'halogénure d'argent selon l'une quelconque des revendications 1 à 3, caractérisé en ce que la couche d'émulsion à l'halogénure d'argent comprend en plus un colorant absorbant dans la région spectrale visuelle.

5. Matériau photographique à noircissement direct à base d'halogénure d'argent selon la revendication 4, caractérisé en ce que ce colorant est un colorant filtrant absorbant principalement entre 400 et 450 nm.

6. Matériau photographique à noircissement direct à base d'halogénure d'argent selon l'une quelconque des revendications 1 à 5, caractérisé en ce que l'émulsion à l'halogénure d'argent comprend en plus un absorbeur U.V.

7. Matériau photographique à noircissement direct à base d'halogénure d'argent selon l'une quelconque des revendications 1 à 6, caractérisé en ce que le taux d'argent, exprimé comme AgNO₃, est compris entre 0,40 et 1,0 g/m².

8. Matériau photographique à noircissement direct à base d'halogénure d'argent selon l'une quelconque des revendications 1 à 7, caractérisé en ce que la granularité moyenne de l'émulsion est inférieure à 0,15 µm.

9. Matériau photographique à noircissement direct à base d'halogénure d'argent selon l'une quelconque des revendications 1 à 8, caractérisé en ce que l'accepteur d'halogène est présent dans une concentration d'au moins 5.10⁻³ moles par mole d'halogénure d'argent.

10. Matériau photographique à noircissement direct à base d'halogénure d'argent selon l'une quelconque des revendications 1 à 9, caractérisé en ce qu'il comprend en plus un développateur.

11. Matériau photographique à noircissement direct à base d'halogénure d'argent selon l'une quelconque des revendications 1 à 10, caractérisé en ce que le support est un support opaque.

12. Matériau photographique à noircissement direct à base d'halogénure d'argent selon la revendication 11, caractérisé en ce que le support est un support en papier.

13. L'usage d'un matériau photographique à noircissement direct à base d'halogénure d'argent selon les revendications 11 ou 12 comme une épreuve de positionnement après l'exposition sous forme d'image à un rayonnement ultraviolet.

14. Matériau photographique à noircissement direct à base d'halogénure d'argent selon l'une quelconque des revendications 1 à 10, caractérisé en ce que le support est un support transparent.

15. Matériau photographique à noircissement direct à base d'halogénure d'argent selon la revendication 14, caractérisé en ce que le support transparent est enduit d'une couche adhésive pelliculable.

16. L'usage d'un matériau à noircissement direct à base d'halogénure d'argent selon la revendication 14 ou 15 comme un auxiliaire de montage après l'exposition sous forme d'image à un rayonnement ultraviolet.

17. L'usage d'un matériau à noircissement direct à base d'halogénure d'argent selon la revendication 14 ou 15 comme une épreuve de positionnement après l'exposition sous forme d'image à un rayonnement ultraviolet.
